# EUROPÄISCHE PATENTANMELDUNG

(11) **EP 3 591 757 A1**
(43) Veröffentlichungstag der Anmeldung: **08.01.2020**
(21) Anmeldenummer: 19184569.2
(22) Anmeldetag: 05.07.2019
(51) Int. Cl.: H01M 10/44, H01M 10/42

(54) **VERFAHREN, COMPUTERPROGRAMMPRODUKT UND PROGNOSESYSTEM ZUR BESTIMMUNG DER LEBENSDAUER EINER ANTRIEBSBATTERIE EINES FAHRZEUGS, INSBESONDERE EINES BOOTS**

(30) Priorität: 06.07.2018 DE 102018116472
(71) Anmelder: Torqeedo GmbH, 82205 Gilching (DE)
(72) Erfinder: Basler, Hendrik, 80634 München (DE); Daude, Michael, 82544 Egling (DE); Hartmeyer, Marc, 81829 München (DE)
(74) Vertreter: Nordmeyer, Philipp Werner

(57) **Zusammenfassung**

Die vorliegende Erfindung betrifft ein Verfahren zur Bestimmung der Lebensdauer einer Antriebsbatterie (12) eines Boots, umfassend die Schritte:
- Bestimmen einer Systemkonfiguration und/oder von Betriebsbedingungen des Boots;
- Bereitstellen eines Antriebsbatteriemodells, das in Abhängigkeit der Systemkonfiguration und/oder der Betriebsbedingungen einen Alterungszustand der Antriebsbatterie (12) im Zeitverlauf angibt;
- Bestimmen wenigstens einer Bedingung, die das Erreichen eines Lebensende-Zustandes der Antriebsbatterie (12) festlegt; und
- Berechnen der Zeitdauer bis zum Erreichen des Lebensende-Zustandes auf der Grundlage des Antriebsbatteriemodells.

## Beschreibung

### Technisches Gebiet

Die vorliegende Erfindung betrifft ein Verfahren zur Bestimmung der Lebensdauer einer Antriebsbatterie eines Fahrzeugs, insbesondere eines Boots, ein Computerprogrammprodukt zum Durchführen des Verfahrens und ein Prognosesystem mit einem derartigen Computerprogrammprodukt.

### Stand der Technik

Elektrisch angetriebene Wasserfahrzeuge, insbesondere Boote, sind mit einem wiederaufladbaren elektrischen Energiespeicher, beispielsweise in Form einer Antriebsbatterie, ausgestattet, der elektrische Energie speichert und diese zur Versorgung eines elektrischen Antriebsmotors bedarfsgerecht bereitstellt. Derartige Energiespeicher sind kostenintensiv und weisen typischerweise eine Lebensdauer auf, die kürzer ist im Vergleich zu einer Lebensdauer des Wasserfahrzeugs und des elektrischen Antriebssystems an sich.

Elektrische Energiespeicher unterliegen einer physikalischen Alterung, die mit zunehmender Betriebsdauer und Zeit eine abnehmende Leistungsfähigkeit bewirkt. Der ordnungsgemäße und sichere Betrieb des elektrischen Antriebssystems ist somit abhängig von dem Alterungszustand bzw. der mit fortschreitendem Alter und Betriebszeit abnehmenden Gebrauchstüchtigkeit des Energiespeichers. Alterungseffekte des elektrischen Energiespeichers hängen von einer Vielzahl von unterschiedlichen Faktoren ab. Im Allgemeinen kann zwischen die Einsatzumgebung des Boots betreffenden, sogenannten äußeren Faktoren und betriebsbedingten, sogenannten inneren Faktoren unterschieden werden. Die die Alterungseffekte beeinflussenden äußeren Faktoren sind zum Beispiel klimatische Bedingungen des Einsatzgebiets, insbesondere die Umgebungstemperatur und Luftfeuchtigkeit. Zu den inneren Faktoren zählen beispielsweise die Anzahl von Lade- und Entladezyklen, das Alter des Energiespeichers, die Betriebstemperatur des Energiespeichers, etc.

Aus dem Stand der Technik sind eine Vielzahl von Verfahren bekannt, um den Alterungszustand, also die Gebrauchstüchtigkeit eines elektrischen Energiespeichers zu bestimmen. Als Kennzahl für den Alterungszustand (engl.: "State of Health"; kurz: SOH) kann beispielsweise eine Abnahme der Speicherfähigkeit gegenüber einem Neuzustand des Energiespeichers herangezogen werden. Ein allgemein bekanntes Verfahren zur genauen Bestimmung der Gebrauchstüchtigkeit sieht vor, den elektrischen Energiespeicher zunächst vollständig aufzuladen und daraufhin vollständig zu entladen, um eine vorherrschende Speicherfähigkeit zu messen. Bei einem weniger kosten- und zeitintensiven Verfahren ist es bekannt, einen inneren Widerstand des Energiespeichers zu messen, um daraufhin einen vorherrschenden Alterungszustand, d. h. einen Ist-Alterungszustand zu bestimmen.

Um eine einsatzgerechte und kostenoptimierte Auslegung elektrischer Antriebssysteme sicherzustellen, sollte insbesondere der elektrische Energiespeicher an die spezifischen Einsatzbedingungen und das vorgesehene Nutzungsverhalten des Boots angepasst werden. Entsprechend bedarf eine optimierte Auslegung des elektrischen Antriebssystems eine zuverlässige Prognose des Alterungszustandes des Energiespeichers über die Betriebsdauer. Mit anderen Worten, es besteht Bedarf an einem Verfahren, das den Alterungszustand des Energiespeichers im Zeitverlauf während des Betriebs prognostiziert.

Ein derartiges Verfahren sollte vorteilhafterweise dazu geeignet sein, den Alterungszustand des Energiespeichers im Zeitverlauf bereits vor dessen eigentlicher Inbetriebnahme zuverlässig zu prognostizieren. Ferner sollte ein derartiges Verfahren auch während des Betriebs der Antriebsbatterie verwendet werden können, um eine verbleibende Lebensdauer der Antriebsbatterie zu bestimmen. Für die Prognose des Alterungszustandes ist insbesondere der Zeitpunkt von Interesse, an dem die Leistungsfähigkeit des Energiespeichers den an diesen gestellten Anforderungen nicht länger gerecht wird und somit ein Ende seiner Lebensdauer erreicht hat. Unter dem Begriff "Lebensdauer" wird vorliegend die Zeitdauer von Beginn bis Ende eines ordnungsgemäßen Betriebs des Energiespeichers verstanden.

Hier sind auch die besonderen Bedingungen auf einem Boot zu berücksichtigen, sowohl bezüglich der Umgebungsbedingungen, als auch bezüglich der Notwendigkeit, eine Mindestreichweite bereit zu stellen, die das Erreichen eines Hafens oder von Land sicher ermöglicht. Diese sicherheitsrelevante Anforderung kann sich von den Anforderungen für Landfahrzeuge unterscheiden, bei denen eine zu geringe Reichweite selten in lebensbedrohenden Situationen enden kann.

Aus der US 2003/065366 A1 und US 7,880,438 B1 sind Verfahren zum Bestimmen eines Lebensende-Zustandes einer Batterie bekannt, bei denen Betriebsparameter, wie beispielsweise eine Ausgabespannung, zu unterschiedlichen Zeitpunkten nach Aufnahme eines Betriebs der Batterie gemessen werden. Auf Grundlage dieser Messungen erfolgt eine Abschätzung der verbleibenden Batterielebensdauer.

### Darstellung der Erfindung

Ausgehend von dem bekannten Stand der Technik ist es eine Aufgabe der vorliegenden Erfindung, ein verbessertes Verfahren anzugeben, das eine Bestimmung der Lebensdauer einer Antriebsbatterie eines Fahrzeugs, insbesondere eines Boots, ermöglicht. Ferner liegt der Erfindung die Aufgabe zugrunde, ein Computerprogrammprodukt und ein Prognosesystem zum Durchführen eines derartigen Verfahrens bereitzustellen.

Die Aufgaben werden durch ein Verfahren zur Bestimmung der Lebensdauer einer Antriebsbatterie eines Fahrzeugs, insbesondere eines Boots, mit den Merkmalen des Anspruchs 1, ein Computerprogrammprodukt mit den Merkmalen des Anspruchs 13 und ein Prognosesystem mit den Merkmalen des Anspruchs 14 gelöst. Vorteilhafte Weiterbildungen ergeben sich aus den Unteransprüchen.

Entsprechend wird ein Verfahren zur Bestimmung der Lebensdauer einer Antriebsbatterie eines Fahrzeugs, insbesondere eines Boots, vorgeschlagen. Das Verfahren umfasst die Schritte des Bestimmens einer Systemkonfiguration und/oder von Betriebsbedingungen des Fahrzeugs, des Bereitstellens eines Antriebsbatteriemodells, das in Abhängigkeit der Systemkonfiguration und/oder der Betriebsbedingungen einen Alterungszustand der Antriebsbatterie im Zeitverlauf angibt, und des Bestimmens wenigstens einer Bedingung, die das Erreichen eines Lebensende-Zustandes der Antriebsbatterie festlegt. Ferner erfolgt ein Berechnen der Zeitdauer bis zum Erreichen des Lebensende-Zustandes auf der Grundlage des Antriebsbatteriemodells.

Der vorliegenden Erfindung liegt die Erkenntnis zugrunde, dass eine Alterung der Antriebsbatterie dem Einfluss einer Vielzahl unterschiedlicher Faktoren unterliegt. Neben betriebsbedingten, den sogenannten inneren Faktoren wird die Lebensdauer der Antriebsbatterie weiterhin beeinflusst von den die Einsatzumgebung betreffenden, sogenannten äußeren Faktoren. Genauer hat die vorliegende Erfindung erkannt, dass für eine zuverlässige Ermittlung der Lebensdauer einer Antriebsbatterie eine vorgesehene Nutzung und ein vorgesehenes Nutzungsverhalten des Fahrzeugs, betreffend die Art, Intensität und den Ort der Nutzung, zu berücksichtigen ist. Entsprechend erfolgt in dem vorgeschlagenen Verfahren ein Bestimmen der Systemkonfiguration und/oder von Betriebsbedingungen, mittels derer eine vorgesehene Nutzung und ein vorgesehenes Nutzungsverhalten des Fahrzeugs abbildbar sind. Weiterhin wird das Bereitstellen des Antriebsbatteriemodells vorgeschlagen, das die in dem Verfahren bestimmte Systemkonfiguration und/oder die bestimmten Betriebsbedingungen als Eingangsparameter nutzt, um den Alterungszustand der Antriebsbatterie im Zeitverlauf anzugeben und so zu prognostizieren. Im Ergebnis ermöglicht das Verfahren daher eine Bestimmung der Lebensdauer einer Antriebsbatterie eines Fahrzeugs in Abhängigkeit der vorgesehenen Nutzung und des vorgesehenen N utzu ngsverhaltens.

Im Vergleich zu aus dem Stand der Technik bekannten Verfahren können durch die hier vorgeschlagene Lösung eine Vielzahl unterschiedlicher, bislang nicht berücksichtigter Faktoren bei der Berechnung der Lebensdauer einer Antriebsbatterie berücksichtigt werden. Dies ermöglicht eine benutzer- und nutzungsspezifische Bestimmung der Lebensdauer der Antriebsbatterie, was die Zuverlässigkeit und Genauigkeit des Verfahrens verbessert.

Ferner ermöglicht das vorgeschlagene Verfahren, dass eine Bestimmung der Lebensdauer der Antriebsbatterie auch bereits vor deren Inbetriebnahme erfolgen kann. Dies wird dadurch erreicht, dass sich das Verfahren des Antriebsbatteriemodells bedient, das die Zeitdauer zum Erreichen des Lebensende-Zustandes auf der Grundlage der im Verfahren bestimmten Systemkonfiguration und/oder Betriebsbedingungen berechnet. Das Verfahren kann beispielsweise von einem Prognosesystem oder einem Prognosetool, beispielsweise in Form eines Computerprogrammproduktes, durchgeführt werden, das die Zeitdauer bis zum Erreichen des Lebensende-Zustandes einer Antriebsbatterie bereits vor deren Inbetriebnahme oder im Betrieb der Antriebsbatterie berechnet. Alternativ oder zusätzlich kann das Verfahren von einer Steuereinheit oder einem Batteriemanagementsystem in einem Antriebssystem des Fahrzeugs ausgeführt werden, um den Alterungszustand während des Betriebs der Antriebsbatterie zu überwachen.

Unter dem Begriff "Systemkonfiguration" wird vorliegend ein struktureller und funktionaler Aufbau des elektrisch angetriebenen Fahrzeugs, insbesondere des elektrischen Antriebssystems samt Antriebsbatterie verstanden. Insbesondere sind darunter die strukturelle und funktionale Ausgestaltung einzelner Systemkomponenten und deren Zusammenwirken umfasst.

Der grundlegende Aufbau eines elektrisch angetriebenen Fahrzeugs, insbesondere Boots, ist dem Fachmann aus dem Stand der Technik bekannt und ist daher hier nicht im Detail beschrieben. Im Allgemeinen umfasst ein elektrisch angetriebenes Fahrzeug ein elektrisches Antriebssystem mit wenigstens einer Antriebsbatterie, die mit einem oder mehreren Verbrauchern, insbesondere wenigstens einem Antriebsmotor, verbunden ist und diese mit elektrischer Energie versorgt. Die Anzahl und der Typ der in einem Fahrzeug verwendeten Antriebsbatterien und deren Zusammenschaltung hängen unter anderem von dem Typ, der vorgesehenen Nutzung und den typischen Anwendungsfällen des Fahrzeugs und der darin verbauten elektrischen Verbraucher ab.

Eine Antriebsbatterie umfasst üblicherweise eine Vielzahl von Batteriezellen, die miteinander unterschiedlich verschaltet sein können. Entsprechend kann das Fahrzeug auch mehrere Antriebsbatterien aufweisen, die ebenfalls auf unterschiedliche Weise miteinander verschaltet sein können. Die Parallelschaltung von einzelnen Antriebsbatterien oder Batteriezellen innerhalb der Antriebsbatterien erhöht deren Speicherkapazität und Strombelastbarkeit. Demgegenüber kann durch eine serielle Zusammenschaltung von einzelnen Antriebsbatterien oder Batteriezellen eine Abgabespannung erhöht werden.

Der Verfahrensschritt des Bestimmens der Systemkonfiguration kann entsprechend ein Bestimmen der Anzahl der Antriebsbatterien und/oder des Batterietyps der einzelnen Antriebsbatterien und/oder der Art der Zusammenschaltung der Antriebsbatterien umfassen. Alternativ oder zusätzlich kann ein Bestimmen der Anzahl von Batteriezellen in den einzelnen Antriebsbatterien und/oder der Art der Zusammenschaltung der Batteriezellen innerhalb der einzelnen Antriebsbatterien erfolgen. Ferner kann ein Bestimmen der Anzahl und des Typs der mit der wenigstens einen Antriebsbatterie verbundenen Verbraucher, insbesondere die Bestimmung wenigstens eines Antriebsmotors und/oder weiterer Verbraucher, erfolgen.

Die Alterung der Antriebsbatterie wird weiterhin durch die Art und Weise des Aufladens beeinflusst. Ein zum Aufladen der Antriebsbatterie verwendetes Ladegerät gibt dabei Aufschluss über den Aufladevorgang der Antriebsbatterie. Entsprechend kann der Verfahrensschritt des Bestimmens der Systemkonfiguration ein Bestimmen eines zur Verwendung vorgesehenen oder verwendeten Ladegeräts umfassen.

Um eine thermische Belastung der Antriebsbatterie zu verringern, kann das elektrische Antriebssystem eine Kühlung umfassen. Die Kühlung kann dafür vorgesehen sein, die Antriebsbatterie zu kühlen, insbesondere im Betrieb des elektrischen Antriebssystems oder bei einem Ladevorgang der Antriebsbatterie. Der Verfahrensschritt des Bestimmens der Systemkonfiguration kann weiterhin ein Bestimmen eines Vorhandenseins und/oder eine Art und/oder einer Kühlleistung einer Kühlung für die Antriebsbatterie umfassen.

Der Begriff "Betriebsbedingungen" betrifft im Zusammenhang der vorliegenden Offenbarung Informationen über die Art, Intensität und den Ort des Betriebs und der Nutzung des Fahrzeugs, insbesondere der Antriebsbatterie. Die Betriebsbedingungen beziehen sich sowohl auf äußere als auch auf innere Faktoren, die die Alterung der Antriebsbatterie beeinflussen.

Der Verfahrensschritt des Bestimmens der Betriebsbedingungen kann ein Bestimmen einer vorgesehenen Einsatzregion des Fahrzeugs und/oder von Klimabedingungen, insbesondere eines Klimaprofils, der vorgesehenen Einsatzregion umfassen. Auf diese Weise können Informationen zu der Umgebungstemperatur und der Luftfeuchtigkeit in der vorgesehenen Einsatzregion des Fahrzeugs bestimmt, dem Antriebsbatteriemodell zur Verfügung gestellt und so bei der Bestimmung der Lebensdauer der Antriebsbatterie berücksichtigt werden.

Alternativ oder zusätzlich kann ein Bestimmen einer in der Antriebsbatterie vorherrschenden Temperatur und/oder einer Temperaturbeschränkung erfolgen. Eine Temperaturbeschränkung für die Antriebsbatterie kann beispielsweise durch die für die Antriebsbatterie vorgesehene Kühlung vorgegeben sein.

Ferner kann ein Bestimmen der Betriebszyklen der Antriebsbatterie, insbesondere bezogen auf deren Lade- und Entladevorgänge, erfolgen. Im Speziellen kann der Schritt des Bestimmens der Ladevorgänge ein Bestimmen einer Lade-Endspannung und/oder einer in der Antriebsbatterie vorherrschenden maximalen Batteriezelltemperatur, insbesondere beim Vorhandensein einer Kühlung für die Antriebsbatterie, und /oder eines Ladestroms umfassen. Beim Bestimmen der Entladevorgänge kann ein Bestimmen einer Entladungstiefe und/oder einer in der Antriebsbatterie vorherrschenden maximalen Batteriezelltemperatur, insbesondere beim Vorhandensein einer Kühlung für die Antriebsbatterie, und/oder einer mittleren und/oder maximalen Leistungsabgabe und/oder einer Dauer der maximalen Leistungsabgabe relativ zu einer gesamten Entladedauer erfolgen. Ferner kann ein Bestimmen einer voraussichtlichen Anzahl von Entlade- bzw. Aufladezyklen, insbesondere bezogen auf einen bestimmten Zeitraum, erfolgen. Beispielsweise kann in diesem Zusammenhang ein Bestimmen einer voraussichtlichen durchschnittlichen Anzahl von Entlade- bzw. Aufladezyklen für vordefinierte Zeiträume, vorzugsweise Jahreszeiten, erfolgen. Die durchschnittliche Anzahl von Entlade- bzw. Aufladezyklen kann für die unterschiedlichen vordefinierten Zeiträume voneinander abweichen.

Alternativ oder zusätzlich kann der Verfahrensschritt des Bestimmens der Betriebsbedingungen das Bestimmen von Lagerungsbedingungen der Antriebsbatterie umfassen. Unter Lagerungsbedingungen werden vorliegend die Art und Umstände beschrieben, unter welchen das Fahrzeug, insbesondere das Boot, oder die Antriebsbatterie gelagert werden. Die Lagerung beschreibt einen Zustand des Fahrzeugs oder der Antriebsbatterie, in dem diese nicht in Gebrauch oder in Betrieb sind. In diesem Zusammenhang kann bestimmt werden, in welcher Umgebung, insbesondere unter welchen Umgebungsbedingungen, wie zum Beispiel die Umgebungstemperatur, die Lagerung erfolgt. Alternativ oder zusätzlich kann bestimmt werden, in welchem Ladungszustand (engl.: "State of Charge, kurz: SOC) sich die Antriebsbatterie bei der Lagerung befindet.

Die Nutzung eines Fahrzeugs und dessen Umgebungsbedingungen variieren typischerweise in Abhängigkeit der Jahreszeiten beziehungsweise des Jahresverlaufs. Um die Betriebsbedingungen möglichst genau und realitätsnah zu bestimmen und gleichzeitig die Handhabung und Bestimmung der Informationen einfach zu halten, schlägt das vorliegende Verfahren in einer Weiterentwicklung vor, die Bestimmung der Betriebsbedingungen für einzelne Jahreszeiten aufzuteilen. Vorzugsweise erfolgt die Bestimmung der Betriebsparameter derart, dass für die einzelnen Jahreszeiten oder Monate eines Kalenderjahres Informationen zu den Betriebsbedingungen gesondert erhoben werden. Entsprechend können die Betriebsbedingungen für den Gebrauch des Fahrzeugs oder der Antriebsbatterie möglichst benutzungsgerecht abgebildet und auf einfache Weise erhoben werden.

Der Verfahrensschritt des Bestimmens der Systemkonfiguration und/oder von Betriebsbedingungen erfolgt vorzugsweise auf der Grundlage von durch einen Benutzer des Fahrzeugs übermittelten Informationen. Alternativ oder zusätzlich kann das Bestimmen der Systemkonfiguration und/oder von Betriebsbedingungen auf der Grundlage von Daten vergleichbarer und/oder früherer Anwendungsfälle erfolgen. Ferner können/kann die Systemkonfiguration und/oder die Betriebsbedingungen auf der Grundlage bereits bestimmter oder vorhandener Informationen bestimmt werden.

Wie vorangehend beschrieben dienen die bestimmte Systemkonfiguration und die bestimmten Betriebsbedingungen als Eingangsparameter für das Antriebsbatteriemodell. Auf Grundlage dieser Informationen wird dann mittels des Antriebsbatteriemodells ein Alterungszustand der Antriebsbatterie im Zeitverlauf, also eine Änderung des Alterungszustandes oder der Gebrauchstüchtigkeit der Antriebsbatterie über die Zeit berechnet.

Das Antriebsbatteriemodell ist vorzugsweise ein mathematisches Modell, das den Alterungszustand der Antriebsbatterie in Abhängigkeit der Zeit abbildet. Entsprechend kann das Antriebsbatteriemodell als eine Funktion beschrieben werden, die in Abhängigkeit der Systemkonfiguration, der Betriebsbedingungen und der Zeit einen Alterungszustand der Antriebsbatterie quantifiziert.

Zur Quantifizierung des Alterungszustands oder der Gebrauchstüchtigkeit der Antriebsbatterie kann das Antriebsbatteriemodell dazu eingerichtet sein, auf der Grundlage der Systemkonfiguration und/oder der Betriebsbedingungen wenigstens einen den Alterungszustand der Antriebsbatterie betreffenden Parameter als Funktion der Zeit anzugeben. Der wenigstens eine Parameter ist vorzugsweise ein Kennwert für den Alterungszustand oder die Gebrauchstüchtigkeit der Antriebsbatterie. Alternativ oder zusätzlich kann der wenigstens eine Parameter ein innerer Widerstand und/oder eine nutzbare Kapazität und/oder eine Klemmspannung und/oder eine Selbstentladungseigenschaft und/oder eine Anzahl durchlaufener Lade- und Entladezyklen der Antriebsbatterie sein. In einer Ausführungsform kann das Antriebsbatteriemodell dazu eingerichtet sein, zunächst einen inneren Widerstand und/oder eine nutzbare Kapazität und/oder eine Klemmspannung und/oder eine Selbstentladungseigenschaft und/oder eine Anzahl durchlaufener Lade- und Entladezyklen der Antriebsbatterie als Funktion der Zeit zu bestimmen und in Abhängigkeit dieser einen Kennwert für den Alterungszustand oder die Gebrauchstüchtigkeit der Antriebsbatterie zu berechnen. Der Kennwert kann beispielsweise in Prozent angegeben werden, wobei ein Wert von 100% einen Zustand zu Beginn des Betriebs oder vor Inbetriebnahme und ein Wert von 0% einen Lebensende-Zustand der Antriebsbatterie anzeigen.

Der Kennwert für den Alterungszustand kann eine nutzbare Kapazität relativ zu einer Anfangs-Kapazität der Antriebsbatterie angeben. Die Anfangs-Kapazität bezieht sich hierbei auf eine Kapazität der Antriebsbatterie zu Beginn deren Lebensdauer, also vor deren Inbetriebnahme. Alternativ kann der Kennwert eine Anzahl bereits durchlaufener Lade- und Entladezyklen relativ zu einem Grenzwert für die Anzahl von Lade- und Entladezyklen sein, bei der der Lebensende-Zustand der Antriebsbatterie erreicht ist.

Wie vorangehend beschrieben, kann das Antriebsbatteriemodell dazu eingerichtet sein, eine Prognose für den Alterungszustand der Antriebsbatterie im Verlauf der Betriebszeit bereitzustellen. Typischerweise ist zwischen einem prognostizierten Ergebnis und einem tatsächlich eintretenden Ergebnis eine prognoseimmanente Abweichung vorhanden, die üblicherweise mit einem zunehmenden zeitlichen Abstand bezogen auf einen Anfangszeitpunkt der Prognose zunimmt. Um diesen Abweichungen Rechnung zu tragen, kann das Antriebsbatteriemodell dazu eingerichtet sein, einen Wertebereich für den Alterungszustand, insbesondere für den wenigstens einen Parameter, in Abhängigkeit der Zeit anzugeben, wobei insbesondere eine Breite des Wertebereichs im Zeitverlauf größer wird. Mit anderen Worten, das Antriebsbatteriemodell kann dazu eingerichtet sein, für einzelne Zeitpunkte innerhalb der Lebensdauer einen Wertebereich für den Alterungszustand anzugeben.

Das vorgeschlagene Verfahren umfasst ferner den Schritt des Bestimmens wenigstens einer Bedingung, die das Erreichen des Lebensende-Zustandes (engl.: end-of-life(EOL)-state) der Antriebsbatterie festlegt. Durch diesen Verfahrensschritt wird dem Umstand Rechnung getragen, dass für unterschiedliche Nutzungen und Anwendungsfälle des Fahrzeugs jeweils verschiedene, kunden- und anwendungsspezifische Lebensende-Zustände definiert sein können. Im Allgemeinen liegt ein Lebensende-Zustand der Antriebsbatterie dann vor, wenn dessen Leistungsfähigkeit den an die Antriebsbatterie gestellten Anforderungen nicht länger gerecht wird und somit ein zuverlässiger und einsatzgerechter Betrieb des Fahrzeugs nicht länger gewährleistet werden kann. Beispielsweise kann für bestimmte Anwendungsfälle des Fahrzeugs ein Lebensende-Zustand der Antriebsbatterie dann erreicht sein, wenn eine nutzbare Kapazität relativ zu einer Anfangs-Kapazität der Antriebsbatterie, insbesondere unter Vorgabe einer konstanten Entlade-Dauerleistung, einen Wert von beispielsweise im Wesentlichen 80% oder 87% unterschreitet.

In einer Ausführungsform des Verfahrens kann das Bestimmen der wenigstens einen Bedingung ein Bestimmen eines Grenzwertes für den Alterungszustand, insbesondere den wenigstens einen Parameter, umfassen. Der Grenzwert bildet bevorzugt einen Wert für den Alterungszustand, insbesondere den wenigstens einen Parameter, bei dessen Erreichen der Lebensende-Zustand der Antriebsbatterie vorliegt. Hierzu kann das Verfahren zusätzlich einen Schritt des Bestimmens eines Grenzwertes für den Alterungszustand umfassen, bei dem auf der Grundlage der wenigstens einen im Verfahren bestimmten Bedingung, der Grenzwert bestimmt wird. Dieser Verfahrensschritt kann beispielsweise durch das Antriebsbatteriemodell erfolgen. Mit anderen Worten, das Antriebsbatteriemodell kann dazu eingerichtet sein, auf der Grundlage der wenigstens einen im Verfahren bestimmten Bedingung einen Grenzwert für den Alterungszustand, insbesondere den wenigstens einen Parameter, zu bestimmen. Entsprechend kann in dem Verfahrensschritt des Berechnens der Zeitdauer bis zum Erreichen des Lebensende-Zustandes bestimmt werden, nach welcher Zeitdauer oder zu welchem Zeitpunkt der Grenzwert erreicht wird.

Zur Validierung des Verfahrens, insbesondere des Antriebsbatteriemodells, können während der Lebensdauer des Fahrzeugs zu bestimmten Zeitpunkten der angegebene Alterungszustand oder der wenigstens eine angegebene Parameter an der Antriebsbatterie gemessen und mit den prognostizierten Werten verglichen werden. Entsprechend kann das Verfahren einen Schritt des Messens des Alterungszustandes oder des wenigstens einen Parameters an der Antriebsbatterie umfassen. Ferner kann ein Vergleich zwischen den gemessenen und den durch das Antriebsbatteriemodell angegebenen oder berechneten Werten erfolgen. Zur Verbesserung des Verfahrens kann dann auf der Grundlage des Vergleichs zwischen den berechneten und den gemessenen Werten das Antriebsbatteriemodell angepasst werden. Nach erfolgter Anpassung des Verfahrens, insbesondere des Antriebsbatteriemodels, kann die Lebensdauer der Antriebsbatterie mittels des Verfahrens erneut bestimmt werden. Durch den Vergleich der berechneten und gemessenen Werte für den Alterungszustand und die darauf gestützte Anpassung des Verfahrens, insbesondere des Antriebsbatteriemodels, kann die Genauigkeit und Zuverlässigkeit der Bestimmung der Lebensdauer der Antriebsbatterie sowohl anwendungsspezifisch als auch anwendungsübergreifend erhöht werden.

Die Validierung kann derart erfolgen, dass die durch das Antriebsbatteriemodell angegebenen Werte für den Alterungszustand, insbesondere den wenigstens einen Parameter, zu einem oder mehreren Zeitpunkten während oder am Ende der Lebensdauer der Antriebsbatterie gemessen und zur Anpassung des Verfahrens, insbesondere des Antriebsbatteriemodells, verwendet werden. Genauer kann der durch das Antriebsbatteriemodell angegebene oder berechnete Alterungszustand, insbesondere der wenigstens eine Parameter, während eines Auflagevorgangs der Antriebsbatterie und/oder einer Wartung der Antriebsbatterie und/oder nach Ablauf der berechneten Lebensdauer gemessen werden. Dabei kann eine Validierung und Anpassung des Verfahrens nach jeder der voranstehend genannten Messungen erfolgen und daraufhin die Lebensdauer der Antriebsbatterie erneut bestimmt werden.

In einer Weiterentwicklung des Verfahrens können Betriebsbedingungen während der Lebensdauer der Antriebsbatterie aufgezeichnet werden. In einer Ausführungsform kann der Verfahrensschritt des Bestimmens der Betriebsbedingungen das Aufzeichnen derselben während der Lebensdauer der Antriebsbatterie umfassen. Die aufgezeichneten Betriebsbedingungen werden vorzugsweise dazu genutzt, vorangehend oder initial bestimmte Betriebsbedingungen und/oder das Antriebsbatteriemodell zu verifizieren und bedarfsweise anzupassen. Daraufhin kann dann auf der Grundlage der angepassten Betriebsbedingungen und/oder des angepassten Antriebsbatteriemodells die Lebensdauer der Antriebsbatterie erneut bestimmt werden. Auf diese Weise können die Genauigkeit und die Zuverlässigkeit des Verfahrens weiter verbessert werden.

In einer Weiterentwicklung kann wenigstens ein die Betriebsbedingungen betreffender Parameter in unterschiedliche Wertebereiche aufgeteilt und die Gesamtbetriebszeit der Antriebsbatterie in jedem der durch die Wertebereiche festgelegten Betriebszustände über die Lebensdauer der Antriebsbatterie aufgezeichnet werden. So kann eine effiziente Aufzeichnung der Betriebsbedingungen erfolgen, die eine umfängliche Auswertung bei einer vergleichsweise geringen Datenmenge ermöglicht. Die aufzuzeichnenden Parameter können zu unterschiedlichen Zeitpunkten bzw. in unterschiedlichen Frequenzen aufgezeichnet werden.

Die vorliegende Offenbarung betrifft ferner ein Computerprogrammprodukt mit einem auf einem maschinenlesbaren Datenträger gespeicherten Programmcode zur Durchführung des voranstehend beschriebenen Verfahrens, wenn das Computerprogrammprodukt von einer Datenverarbeitungsanlage ausgeführt wird. Voranstehende, auf das Verfahren gerichtete technische Merkmale betreffen somit entsprechend das hier beschriebene Computerprogrammprodukt zum Durchführen des Verfahrens.

Ferner wird ein Prognosesystem zur Bestimmung der Lebensdauer eine Antriebsbatterie eines Fahrzeugs, insbesondere eines Boots, bereitgestellt, das einen Datenträger umfasst, auf dem das voranstehend beschriebene Computerprogrammprodukt gespeichert ist. Das Prognosesystem umfasst ferner eine Prognoseeinheit, insbesondere eine Datenverarbeitungsanlage, zum Ausführen des auf dem Datenträger gespeicherten Computerprogrammprodukts. Auf das Computerprogrammprodukt gerichtete technische Merkmale betreffen somit entsprechend dass hier beschriebene Prognosesystem.

Der Datenträger der Prognoseeinheit kann in einem Webserver umfasst sein. Die Prognoseeinheit kann dazu eingerichtet sein, auf den Webserver dezentral zuzugreifen und das auf dem Datenträger gespeicherte Computerprogrammprodukt und entsprechend das voranstehende Verfahren zur Bestimmung der Lebensdauer eine Antriebsbatterie eines Fahrzeugs auszuführen.

### Kurze Beschreibung der Figuren

Bevorzugte weitere Ausführungsformen der Erfindung werden durch die nachfolgende Beschreibung der Figuren näher erläutert. Dabei zeigen schematisch:
- Figur 1: ein elektrisches Antriebssystem eines elektrisch angetriebenen Boots und ein Prognosesystem zur Bestimmung der Lebensdauer einer Antriebsbatterie des Antriebssystems;
- Figur 2: ein durch das Prognosesystem auszuführendes Verfahren zur Bestimmung der Lebensdauer der Antriebsbatterie;
- Figuren 3 bis 5: Diagramme, die durch das Verfahren berechnete Parameter und Kennwerte für den Alterungszustand der Antriebsbatterie im zeitlichen Verlauf darstellen; und
- Figur 6: eine Ausführungsform des Antriebsbatteriemodells.

### Detaillierte Beschreibung bevorzugter Ausführungsbeispiele

Im Folgenden werden bevorzugte Ausführungsbeispiele anhand der Figuren beschrieben.

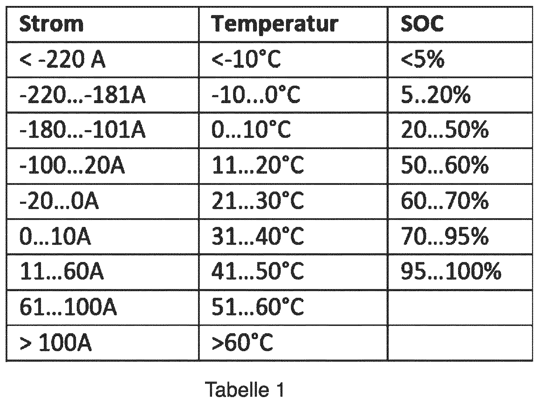

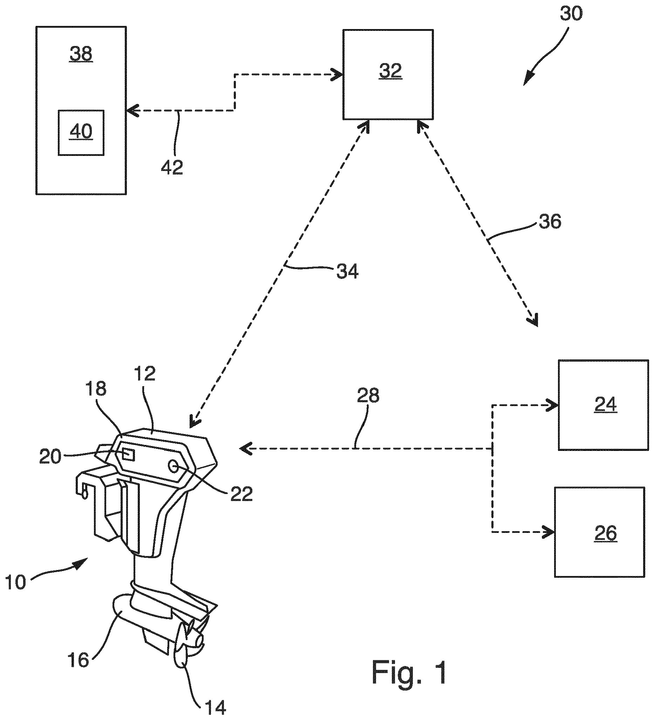

Figur 1 zeigt schematisch ein elektrisches Antriebssystem 10 in Form eines Außenbordmotors für ein Boot. Das elektrische Antriebssystem 10 umfasst eine Antriebsbatterie 12, die mit einem eine Schiffsschraube 14 antreibenden Antriebsmotor 16 und weiteren hier nicht gezeigten elektrischen Verbrauchern des elektrischen Antriebssystems 10 verbunden ist und diese mit elektrischer Energie versorgt. Die Antriebsbatterie 12 ist in einem Gehäuse 18 des elektrischen Antriebssystems 10 lösbar befestigt. Ferner umfasst das Antriebssystem 10 ein Batteriemanagementsystem 20, das mit einem an dem elektrischen Antriebssystem 10 für einen Benutzer sichtbar angebrachten Display verbunden und dazu eingerichtet ist, Kennwerte der Antriebsbatterie 12, wie zum Beispiel einen aktuellen Alterungszustand, also eine Gebrauchstüchtigkeit (kurz: SOH-Wert) der Antriebsbatterie 12, eine voraussichtliche oder verbleibende Lebensdauer der Antriebsbatterie 12, einen Ladungszustand der Antriebsbatterie 12 (kurz SOC-Wert), etc., zu ermitteln und auf dem Display anzuzeigen.

Das Antriebssystem 10 verfügt über eine Schnittstelle 22, über die die Antriebsbatterie 12 zum elektrischen Aufladen mit einem Ladegerät 24 verbindbar ist. Das Ladegerät 24 ist dazu eingerichtet, wenigstens einen den Alterungszustand betreffenden Parameter der Antriebsbatterie 12 zu messen und die gemessenen Werte für den Parameter zusammen mit einem Zeitpunkt der jeweiligen Messung dem Batteriemanagementsystem 20 über die Schnittstelle 22 zu übermitteln. Im Speziellen ist das Ladegerät 24 dazu eingerichtet, einen inneren Widerstand der Antriebsbatterie 12 zu messen, der mit fortschreitendem Alterungszustand der Antriebsbatterie 12 zunimmt.

Die Schnittstelle 22 ist ferner dazu eingerichtet, das Antriebssystem 10 mit einem Messgerät 26 zu verbinden, dass dazu eingerichtet ist, wenigstens einen den aktuellen Alterungszustand anzeigenden Parameter oder Kennwert zu ermitteln und die so ermittelten Werte an das Batteriemanagementsystem 20 zu übermitteln. Genauer ist das Messgerät 26 dazu eingerichtet, eine nutzbare Kapazität und einen Innenwiderstand der Antriebsbatterie 12 zu messen und zusammen mit einem Zeitpunkt der Messung dem Batteriemanagementsystem 20 über die Schnittstelle 22 zu übermitteln. Dies kann beispielsweise erfolgen, indem das Messgerät 26 die Antriebsbatterie 12 zunächst vollständig auflädt und daraufhin mit einer vorgegebenen konstanten Entlade-Dauerleistung vollständig entlädt. Mit anderen Worten, indem das Messgerät 26 eine nutzbare Kapazität misst, kann auf Grundlage dessen ein Ist-Alterungszustand der Antriebsbatterie 12 bestimmt werden. Alternativ kann das Messgerät 26 zum Ausführen einer anderen geeigneten Messmethode eingerichtet sein.

Der Austausch von Informationen über die Schnittstelle 22 zwischen dem elektrischen Antriebssystem 10, insbesondere dem Batteriemanagementsystem 20, und jeweils dem Ladegerät 24 und dem Messgerät 26 ist in Figur 1 durch gestrichelte Linien 28 angedeutet.

In Figur 1 ist weiterhin ein Prognosesystem 30 gezeigt, das zur Bestimmung der Lebensdauer der Antriebsbatterie 12 eingerichtet ist. Das Prognosesystem 30 umfasst eine Prognoseeinheit 32 in Form einer Datenverarbeitungsanlage, die über die Schnittstelle 22 oder eine hier nicht gezeigte weitere Schnittstelle mit dem Antriebssystem 10 zum Austausch von Informationen verbindbar ist, wie in Figur 1 durch eine gestrichelte Linie 34 angedeutet. Weiterhin ist die Prognoseeinheit 32 sowohl mit dem Ladegerät 24 als auch mit dem Messgerät 26 zum Austausch von Informationen verbindbar, wie in Figur 1 durch eine weitere gestrichelte Linie 36 angedeutet. Genauer ist die Prognoseeinheit 32 dazu eingerichtet, die von dem Ladegerät 24 und dem Messgerät 26 gemessenen Werte für die den Alterungszustand der Antriebsbatterie 12 betreffenden Parameter zu empfangen.

Das Prognosesystem 30 umfasst ferner einen Webserver 38 mit einem maschinenlesbaren Datenträger 40, auf dem ein Computerprogrammprodukt gespeichert ist. Die Prognoseeinheit 32 ist mit dem Webserver 38 verbunden, wie durch eine weitere gestrichelte Linie 42 in Figur 1 angedeutet, und dazu eingerichtet, auf das in dem Datenträger 40 enthaltene Computerprogrammprodukt zuzugreifen und dieses auszuführen. Das Computerprogrammprodukt stellt eine Web-basierte Software dar, auf die die Prognoseeinheit 32 zum Durchführen eines Verfahrens zur Bestimmung der Lebensdauer der Antriebsbatterie 12 zugreifen kann. Mit anderen Worten, das Computerprogrammprodukt umfasst einen auf dem Datenträger gespeicherten Programmcode zum Durchführen des Verfahrens zur Bestimmung der Lebensdauer der Antriebsbatterie, wenn das Computerprogrammprodukt von der Prognoseeinheit 32 ausgeführt wird.

Die Prognoseeinheit 32 ist insbesondere eine dezentrale Datenverarbeitungsanlage, beispielsweise in Form eines Personalcomputers, der auf den Webserver zum Ausführen des Computerprogrammprodukts zugreift. Mit anderen Worten, die Prognoseeinheit 32 ist dazu eingerichtet, auf den Webserver 38 dezentral zuzugreifen, um das auf dem Datenträger 40 gespeicherte Computerprogrammprodukt auszuführen. Dies hat den Vorteil, dass das Computerprogrammprodukt und damit das diesem zugrunde liegende Verfahren zum Bestimmen des Alterungszustandes zentral verwaltet und angepasst werden kann.

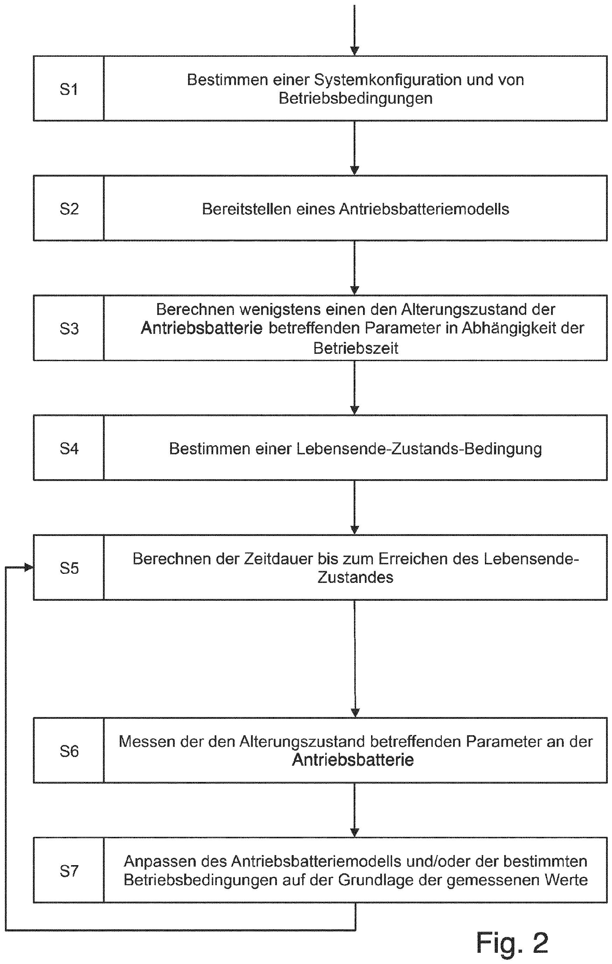

Unter Bezugnahme auf Figur 2 wird im Folgenden das durch die Prognoseeinheit 32 durchzuführende Verfahren zur Bestimmung der Lebensdauer der Antriebsbatterie 12 genauer erläutert. Die Prognoseeinheit 32 kann dabei von einem Benutzer vor Inbetriebnahme oder während des Betriebs der Antriebsbatterie 12 betätigt werden, um das Verfahren zur Bestimmung der Lebensdauer der Antriebsbatterie 12 durchzuführen. Mit anderen Worten, indem durch die Prognoseeinheit 32 das Verfahren ausgeführt wird, berechnet die Prognoseeinheit 32, nach welcher voraussichtlichen Betriebszeit ein Lebensende-Zustand der Antriebsbatterie 12 erreicht wird.

Aufgrund der hohen Anschaffungskosten der Antriebsbatterie 12 ist es bekannt, beim Kauf eines elektrischen Antriebssystems 10 die Antriebsbatterie 12 zu mieten oder zu leasen. Indem die Prognoseeinheit 32 eine voraussichtliche Lebensdauer der Antriebsbatterie 12 berechnet, kann diese eine Grundlage für die Berechnung von kunden- und einsatzspezifischen Finanzierungsmodellen bereitstellen. Ferne bietet die Prognoseeinheit 32 die Möglichkeit einer einsatzgerechten und kostenoptimierten Auslegung des elektrischen Antriebssystems, insbesondere der Antriebsbatterie.

In dem in Figur 2 gezeigten Verfahren erfolgt eine einsatz- und kundenspezifische Berechnung der Zeitdauer bis zum Erreichen des Lebensende-Zustandes. Dies wird dadurch sichergestellt, dass in dem Verfahren die Berechnung unter Bezugnahme auf eine Systemkonfiguration und Betriebsbedingungen des Boots oder des elektrischen Antriebssystems 10 durchgeführt wird. Entsprechend umfasst das Verfahren einen ersten Schritt S1 des Bestimmens einer Systemkonfiguration und von Betriebsbedingungen des Boots.

In dem vorliegenden Ausführungsbeispiel erfolgt dies durch Eingabe von die Systemkonfiguration und die Betriebsbedingungen betreffenden Daten in die Prognoseeinheit 32. Hierzu umfasst die Prognoseeinheit 32 eine grafische Benutzerschnittstelle und eine Eingabeeinrichtung, über die der Benutzer die die Systemkonfiguration und die Betriebsbedingungen betreffende Daten in die Prognoseeinheit 32 eingibt.

Im Hinblick auf die zu bestimmende Systemkonfiguration im Schritt S1 erfolgt eine Eingabe von Daten durch den Benutzer, betreffend:
- die Anzahl von Antriebsbatterien 12;
- den Batterietyp der jeweiligen Antriebsbatterie 12;
- die Art der Zusammenschaltung der Antriebsbatterien, beispielsweise ob diese parallel oder in Reihe geschaltet sind;
- die Anzahl und Zusammenschaltung von Batteriezellen innerhalb der jeweiligen Antriebsbatterie 12;
- die Eigenschaften, insbesondere Leistung, und/oder den Typ des Antriebsmotors 16;
- weitere Verbraucher innerhalb des Antriebsbatteriesystems 10, insbesondere eine summierte Leistung der weiteren Verbraucher während des Betriebs des Antriebssystems 10;
- das zum Aufladen der Antriebsbatterie 12 zu verwendende Ladegerät 24;
- eine von dem Ladegerät 24 induzierte maximale Stromstärke beim Aufladen der Antriebsbatterie 12; und/oder
- ein Kühlsystem zum Kühlen der Antriebsbatterie 12, die eine maximale Betriebstemperatur der Antriebsbatterie 12 sicherstellt.

Weiterhin erfolgt in dem Schritt S1 im Hinblick auf die zu bestimmenden Betriebsbedingungen die Eingabe von Daten durch den Benutzer, betreffend:
- eine vorgesehene Einsatzregion oder einen vorgesehenen Einsatzort des Boots, auf deren Grundlage die Prognoseeinheit ein Temperaturprofil, also einen Verlauf der Temperatur über ein Jahr bestimmt;
- eine durch die Kühlung oder einer Heizung einzuhaltende Höchst- oder Mindesttemperatur innerhalb der Antriebsbatterie 12;
- eine vorgesehene Anzahl von Betriebszyklen; und/oder
- Lagerungsbedingungen der Antriebsbatterie 12.

Die Eingabe der vorgesehenen Anzahl von Betriebszyklen kann derart erfolgen, dass für die jeweiligen Jahreszeiten, also Frühling, Sommer, Herbst und Winter, jeweils eine durchschnittliche Anzahl an Betriebszyklen durch den Benutzer eingegeben wird. Auf diese Weise kann die Eingabe der Betriebsbedingungen für den Benutzer vereinfacht werden, gleichzeitig lassen sich aber die Betriebsbedingungen ausreichend genau abbilden. Beispielsweise kann der Benutzer für jede Jahreszeit eine durchschnittliche Anzahl von Betriebszyklen pro Woche abschätzen und eingeben.

In einem darauffolgenden Schritt S2 des Verfahrens erfolgt ein Bereitstellen eines Antriebsbatteriemodells, das in Abhängigkeit der Systemkonfiguration und/oder der Betriebsbedingungen einen Alterungszustand der Antriebsbatterie 12 im Zeitverlauf, also in Abhängigkeit der Zeit angibt. Genauer handelt es sich bei dem Antriebsbatteriemodell um ein mathematisches Modell, das in Abhängigkeit der Systemkonfiguration, der Betriebsbedingungen und der Betriebszeit einen Alterungszustand der Antriebsbatterie 12 quantifiziert. Das Antriebsbatteriemodell ist in dem Computerprogrammprodukt umfasst. Entsprechend erfolgt das Bereitstellen des Antriebsbatteriemodells, indem die Prognoseeinheit 32 auf den Webserver 38 und das darin gespeicherte Computerprogrammprodukt zugreift.

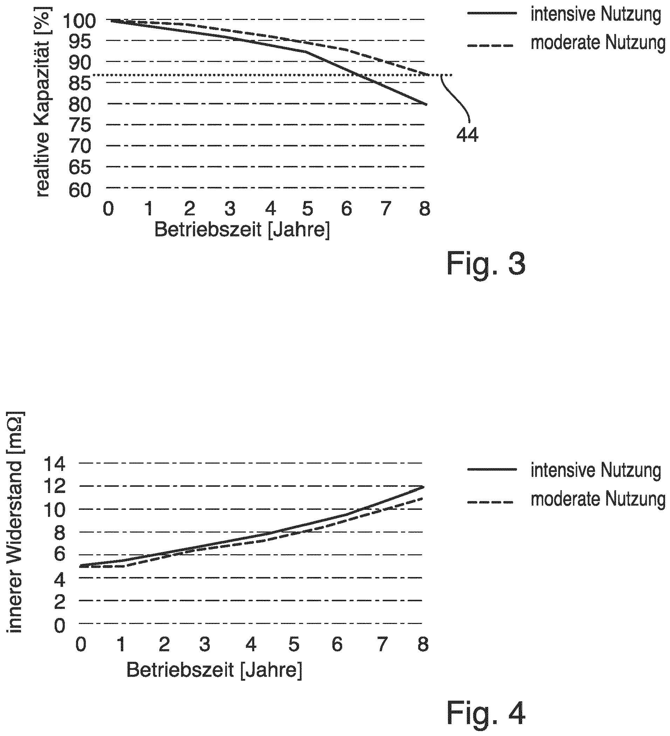

In einem dritten Verfahrensschritt S3 erfolgt mittels des Antriebsbatteriemodells ein Berechnen wenigstens eines den Alterungszustand der Antriebsbatterie 12 betreffenden Parameters oder Kennwerts als Funktion der Zeit. Dies erfolgt im Speziellen auf der Grundlage der im Schritt S1 bestimmten Systemkonfiguration und Betriebsbedingungen. In dem hier gezeigten Ausführungsbeispiel berechnet das Antriebsbatteriemodell als Parameter eine relative Kapazität, wie in Figur 3 gezeigt, und einen inneren Widerstand der Antriebsbatterie 12, wie in Figur 4 gezeigt, im zeitlichen Verlauf. Die relative Kapazität beschreibt ein Verhältnis zwischen einer aktuell zur Verfügung stehenden oder nutzbaren Kapazität relativ zu einer Anfangskapazität der Antriebsbatterie 12, also einer Kapazität vor deren Inbetriebnahme, unter Vorgabe einer konstanten Entlade-Dauerleistung. Die relative Kapazität bildet so einen Kennwert für den Alterungszustand der Antriebsbatterie 12.

Figur 3 zeigt im Speziellen ein Diagramm, in dem die durch das Antriebsbatteriemodell berechnete relative Kapazität im Zeitverlauf dargestellt ist. Die Ordinate des Diagramms zeigt die relative Kapazität in Prozent und die Abszisse des Diagramms die Betriebszeit in Jahren. Da mit zunehmendem Alter die Leistungsfähigkeit der Antriebsbatterie 12 abnimmt, sinkt entsprechend die nutzbare und somit die relative Kapazität der Antriebsbatterie 12, wie in Figur 3 veranschaulicht. Eine intensive Nutzung der Antriebsbatterie 12 hat somit im Vergleich zu einer moderaten Nutzung eine schnellere Abnahme der relativen Kapazität zur Folge.

Figur 4 zeigt entsprechend ein Diagramm, indem der durch das Antriebsbatteriemodell berechnete innere Widerstand der Antriebsbatterie 12 im zeitlichen Verlauf dargestellt ist. Die Ordinate des Diagramms zeigt den inneren Widerstand in mΩ und die Abszisse des Diagramms die Betriebszeit in Jahren. Ein zunehmender Wert für den inneren Widerstand zeigt dabei eine zunehmende Alterung der Antriebsbatterie 12 an. Entsprechend bewirkt eine intensive Nutzung im Vergleich zu einer moderaten Nutzung der Antriebsbatterie 12 einen schnelleren Anstieg des inneren Widerstandes.

Wie aus den Diagrammen in Figuren 3 und 4 hervorgeht, ist das Antriebsbatteriemodell dazu eingerichtet, für die jeweiligen Zeitpunkte einen zu erwartenden Minimal- und Maximalwert für die Parameter zu bestimmen, die entsprechend eine moderate oder intensive Nutzung der Antriebsbatterie 12 darstellen. Auf diese Weise wird dem Benutzer die Veränderung der jeweiligen Parameter sowohl bei einer moderaten als auch bei einer intensiven Nutzung der Antriebsbatterie 12 dargelegt. Entsprechend wird ein mit fortschreitender Zeit sich aufweitender Wertekorridor oder Wertebereich für die Parameter angegeben. Weiterhin kann so den prognoseimmanenten Unsicherheiten beim Berechnen der Parameter und Kennwerte Rechnung getragen werden.

Das Verfahren umfasst weiterhin einen vierten Schritt S4 des Bestimmens wenigstens einer Bedingung, die das Erreichen eines Lebensende-Zustandes der Antriebsbatterie 12 festlegt. Dies erfolgt, indem der Benutzer einen Grenzwert für wenigstens einen der durch das Antriebsbatteriemodell berechneten Parameter festlegt und der Prognoseeinheit 32 über die grafische Benutzerschnittstelle und die Eingabeeinrichtung übermittelt. Der festgelegte Grenzwert ist somit ein Wert, der anzeigt, dass die Antriebsbatterie 12 ein Lebensende-Zustand aufweist, wenn der durch das Antriebsbatteriemodell berechnete Parameter den Grenzwert erreicht.

In dem hier gezeigten Ausführungsbeispiel legt der Benutzer einen Grenzwert für die relative Kapazität, also die nutzbare Kapazität relativ zu der Anfangs-Kapazität der Antriebsbatterie 12 als Bedingung fest, die das Erreichen des Lebensende-Zustandes anzeigt. Beispielsweise kann der durch den Benutzer festgelegte Grenzwert im Wesentlichen 87% betragen, wie in Fig. 3 durch eine gepunktete Linie 44 angedeutet. Mit anderen Worten, sobald bei einem vorgegebenen konstanten Entladungsstrom die tatsächlich nutzbare Kapazität der Antriebsbatterie 12 einen Wert von 87% der Anfangs-Kapazität der Antriebsbatterie 12 aufweist, ist ein Lebensende-Zustand der Antriebsbatterie 12 erreicht. Alternativ oder zusätzlich kann der Benutzer einen Grenzwert für den inneren Widerstand der Antriebsbatterie 12 als Bedingung festlegen, die das Erreichen des Lebensende-Zustandes anzeigt.

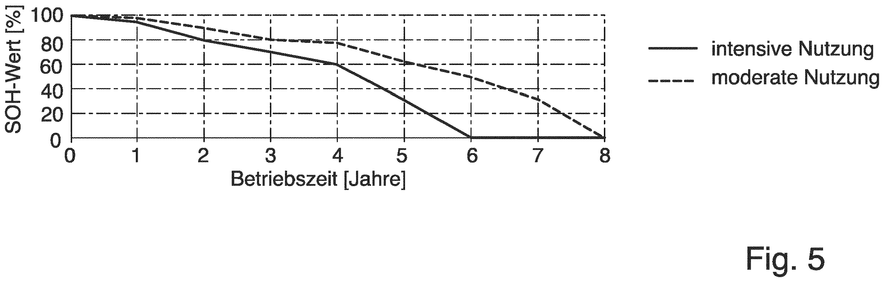

In einem weiteren Schritt S5 des Verfahrens erfolgt dann ein Berechnen der Zeitdauer bis zum Erreichen des Lebensende-Zustandes auf der Grundlage der festgelegten Bedingung und der berechneten Parameter als Funktion der Zeit. Hierfür wird sowohl für die moderate als auch die intensive Nutzung der Antriebsbatterie 12 jeweils eine Zeitdauer bis zum Erreichen des Lebensende-Zustandes, also des festgelegten Grenzwertes, berechnet, wie in Figur 5 gezeigt.

Die Prognoseeinheit 32 ist ferner dazu eingerichtet, auf der Grundlage der zuvor berechneten Parameter, insbesondere der relativen Kapazität und/oder des Innenwiderstands, und der Lebensende-Zustands-Bedingung einen weiteren Kennwert für den Alterungszustand, den SOH-Wert, im zeitlichen Verlauf zu berechnen. Der berechnete SOH-Wert im zeitlichen Verlauf ist in dem Diagramm gemäß Figur 5 veranschaulicht. Die Ordinate des Diagramms zeigt den SOH-Wert in Prozent, wobei ein Wert von 100% den Anfangszustand der Antriebsbatterie 12, also zu Beginn des Betriebs oder vor Inbetriebnahme der Antriebsbatterie 12, und ein Wert von 0 % den Lebensende-Zustand der Antriebsbatterie 12 angeben. Die Abszisse des Diagramms zeigt die Betriebszeit in Jahren. Alternativ können auf der Grundlage der jeweiligen zuvor berechneten Parameter, also der relativen Kapazität und des Innenwiderstands, unterschiedliche oder mehrere SOH-Werte ermittelt werden. Beispielsweise können ein erster SOH-Wert auf der Grundlage der relativen Kapazität und ein zweiter SOH-Wert auf der Grundlage des Innenwiderstandes bestimmt werden. Hierzu werden für die jeweils berechneten Parameter gesonderte Bedingungen festgelegt, die das Erreichen des Lebensende-Zustandes der Antriebsbatterie 12 anzeigen.

Entsprechend den berechneten Parametern wird für die jeweiligen Zeitpunkte der Betriebszeit jeweils ein SOH-Wert sowohl für eine moderate als auch für eine intensive Nutzung berechnet. Auf diese Weise wird ein mit fortschreitender Zeit sich aufweitender Wertekorridor oder Wertebereich für den SOH-Wert angegeben. Einhergehend mit der Unterscheidung zwischen der moderaten und der intensiven Nutzung variiert entsprechend die Zeitdauer bis zum Erreichen des Lebensende-Zustandes. Da durch eine intensive Nutzung eine Alterung der Antriebsbatterie 12 schneller voranschreitet, ist die Lebensdauer der Antriebsbatterie 12 entsprechend kürzer. Wie aus Figur 5 hervorgeht, wird durch das vorliegende Ausführungsbeispiel des Verfahrens bei einer moderaten Nutzung der Antriebsbatterie 12 eine Betriebszeit von ungefähr 8 Jahren und bei einer intensiven Nutzung eine Betriebszeit von ungefähr 6 Jahren als Zeitdauer bis zum Erreichen des Lebensende-Zustandes der Antriebsbatterie 12 angegeben.

Die vorangehend beschriebenen Verfahrensschritte S1 bis S5 können sowohl vor Inbetriebnahme als auch während des Betriebs der Antriebsbatterie 12 zur Bestimmung der Lebensdauer, insbesondere der noch verbleibenden Lebensdauer der Antriebsbatterie 12 durchgeführt werden.

Zum Validieren und Anpassen der durch die Prognoseeinheit 32 berechneten Lebensdauer ist in dem Verfahren weiterhin vorgesehen, die durch die Prognoseeinheit 32 berechneten Parameter während des Betriebs an der Antriebsbatterie 12 zu messen, die gemessenen Werte mit den prognostizierten Werten zu vergleichen und auf Grundlage dieses Vergleichs das Verfahren zur Bestimmung oder das Antriebsbatteriemodell der Lebensdauer anzupassen.

Hierzu erfolgt in einem Verfahrensschritt S6 ein Messen der den Alterungszustand betreffenden Parameter an der Antriebsbatterie 12, insbesondere des inneren Widerstandes und der nutzbaren oder relativen Kapazität. Zum Messen des inneren Widerstandes der Antriebsbatterie 12 wird das Antriebssystem 10 mit dem Ladegerät 24 oder dem Messgerät 26 verbunden, die zum Messen des inneren Widerstands der Antriebsbatterie 12 eingerichtet sind. Dies kann beispielsweise während eines Aufladevorgangs erfolgen. Entsprechend wird zum Messen der nutzbaren Kapazität der Antriebsbatterie 12 das Antriebssystem 10 mit dem Messgerät 26 verbunden, das zum Messen der nutzbaren oder relativen Kapazität eingerichtet ist. Das Messen der nutzbaren oder relativen Kapazität kann beispielsweise während einer Wartung der Antriebsbatterie 12 und/oder nach Ablauf der berechneten Lebensdauer erfolgen. Die durch das Ladegerät 24 und das Messgerät 26 gemessenen Werte werden daraufhin über die Schnittstelle 22 an das Batteriemanagementsystem 20 übermittelt und darin unter Bezugnahme auf die Betriebszeit zum Zeitpunkt der Messung gespeichert. Zusätzlich können die so gemessenen Werte an die Prognoseeinheit 32 übermittelt werden. In einem nächsten Schritt werden die durch das Ladegerät 24 und das Messgerät 26 gemessenen Werte für die den Alterungszustand betreffenden Parameter mit den durch die Prognoseeinheit berechneten Werten verglichen. Dies erfolgt mittels der Prognoseeinheit 32.

Das Batteriemanagementsystem 20 ist ferner dazu eingerichtet, während der Betriebszeit, also der Lebensdauer der Antriebsbatterie 12, Betriebsbedingungen zu messen und aufzuzeichnen. Die derart gemessenen Daten werden auch als sogenannte "Logging Daten" bezeichnet. Hierzu werden zunächst Betriebsbedingungen kennzeichnende Parameter, wie zum Beispiel ein Stromwert, eine Temperatur und der SOC-Wert der Antriebsbatterie 12, in unterschiedliche Wertebereiche aufgeteilt, wie in Tabelle 1 gezeigt. Die unterschiedlichen Wertebereiche kennzeichnen dabei unterschiedliche Betriebszustände der Antriebsbatterie 12. Aufbauend darauf ist das Batteriemanagementsystem 20 dazu eingerichtet, eine Gesamtbetriebszeit der Antriebsbatterie 12 in jedem der durch die Wertebereiche festgelegten Betriebszustände über die Lebensdauer der Antriebsbatterie 12 aufzuzeichnen.

Darüber hinaus ist das Batteriemanagementsystem 20 dazu eingerichtet, weitere die Betriebsbedingungen kennzeichnende Parameter, insbesondere die Anzahl der Betriebszyklen, Zelltemperatur, eine Lagerspannung, einen Entladungsgrad, eine Packspannung und eine maximale Zelldifferenz, zu periodischen Zeitpunkten, beispielsweise alle 8 Stunden, auch in einem ausgeschalteten Zustand der Antriebsbatterie 12, aufzuzeichnen. Die durch das Batteriemanagementsystem 20 aufgezeichneten Parameter werden daraufhin der Prognoseeinheit 32 zur Verfügung gestellt.

Die Prognoseeinheit 32 ist dazu eingerichtet, die mittels des Batteriemanagementsystems 20 aufgezeichneten Werte mit den in dem Verfahrensschritt S1 bestimmten Werten für die Betriebsbedingung zu vergleichen.

Auf der Grundlage der voranstehenden Vergleiche zwischen den initial bestimmten oder berechneten und den im Betrieb gemessenen oder aufgezeichneten Parameter erfolgt daraufhin in einem Verfahrensschritt S7 ein Anpassen des Antriebsbatteriemodells und/oder der bestimmten Betriebsparameter. Dies erfolgt mittels des Prognosesystems 30. Auf diese Weise kann die Zuverlässigkeit des Verfahrens und somit die Genauigkeit der berechneten Lebensdauer bis zum Erreichen des Lebensende-Zustandes verbessert werden.

Nach erfolgter Anpassung des Antriebsbatteriemodells und/oder der bestimmten Betriebsparameter im dem Verfahrensschritt S7 kann dann der Verfahrensschritte S5 des Berechnens der Zeitdauer, insbesondere der verbleibenden Zeitdauer bis zum Erreichen des Lebensende-Zustandes erneut ausgeführt werden.

Die Prognoseeinheit 32 ist ferner dazu eingerichtet, auf der Grundlage des Antriebsbatteriemodells die durch das Batteriemanagementsystem 20 voraussichtlich aufzuzeichnenden Daten und Werte, betreffend die die Betriebsbedingungen kennzeichnende Parameter, zu berechnen und an das Batteriemanagementsystem 20 zu übergeben. Somit werden dem Batteriemanagementsystem 20 die prognostizierten Werte für die den Alterungszustand betreffenden und die die Betriebsbedingungen kennzeichnenden Parameter übermittelt.

Weiterhin empfängt das Batteriemanagementsystem 20 die von dem Ladegerät 24 und dem Messgerät 26 gemessenen Werte für die den Alterungszustand betreffenden Parameter mit Bezugnahme auf den Zeitpunkt der Messung. Wie vorangehend beschrieben, zeichnet das Batteriemanagementsystem 20 zudem die die Betriebsbedingungen kennzeichnenden Parameter während des Betriebs auf.

Mit anderen Worten, dem Batteriemanagementsystem 20 stehen somit jeweils die prognostizierten Werte als auch die gemessenen oder aufgezeichneten Werte für die jeweiligen Parameter im Betrieb des Antriebssystems 10 zur Verfügung. Das Batteriemanagementsystem 20 ist dabei dazu eingerichtet, während des Betriebs die aufgezeichneten oder gemessenen Werte mit den berechneten Werten zu vergleichen und auf Grundlage dieses Vergleichs zu bewerten, ob die durch die Prognoseeinheit 32 berechnete Zeitdauer bis zum Erreichen des Lebensende-Zustandes voraussichtlich eingehalten wird oder nicht. Überschreitet beispielsweise die Anzahl aufgezeichneter Betriebszyklen eine durch die Prognoseeinheit 32 prognostizierte Anzahl von Betriebszyklen zu einem bestimmten Zeitpunkt des Betriebs, zeigt das Batteriemanagementsystem 20 an, dass eine tatsächliche Nutzung des Antriebssystems 10 gegenüber einer ursprünglich geplanten Nutzung höher ist, sodass die voraussichtliche Zeitdauer bis zum Erreichen des Lebensende-Zustandes der Antriebsbatterie 12 kürzer sein wird als durch die Prognoseeinheit 32 berechnet. Das Batteriemanagementsystem 20 ist dazu eingerichtet, den durch die Prognoseeinheit 32 übermittelten Wert für die Zeitdauer bis zum Erreichen des Lebensende-Zustandes auf der Grundlage dieses Vergleichs anzupassen und den so angepassten Wert dem Benutzer über das Display anzuzeigen.

Ferner kann das Batteriemanagementsystem 20 dazu eingerichtet sein, eine Leistungsfähigkeit der Antriebsbatterie 12 zu bestimmen. Die Leistungsfähigkeit kann beispielsweise eine Reichweite oder eine Betriebsdauer für unterschiedliche Betriebszustände des Boots, wie zum Beispiel die moderate oder intensive Nutzung, sein. Das Bestimmen der Leistungsfähigkeit kann erfolgen auf der Grundlage des berechneten oder prognostizierten SOH-Werts oder der berechneten oder prognostizierten Parameter im Zeitverlauf, die mittels der Prognoseeinheit 32 übermittelt werden, und/oder auf der Grundlage der mittels des Ladegeräts 24 oder des Messgeräts 26 gemessenen Parameter, insbesondere der relativen Kapazität und des Innenwiderstands, und/oder auf der Grundlage der von dem Antriebssystem 10 gemessenen oder aufgezeichneten Parameter. Die bestimmte Leistungsfähigkeit kann dem Nutzer des Boots über das Display angezeigt werden. Mit anderen Worten, die durch die Prognoseeinheit 32 prognostizierten Werte und/oder die von dem Messgerät 26 und/oder dem Ladegerät 24 gemessenen Werte können von dem Betriebsmanagementsystem 20 dazu genutzt werden, einen Kennwert für die Leistungsfähigkeit, insbesondere eine Reichweite oder eine Betriebsdauer, in Abhängigkeit unterschiedlicher Betriebsmodi des Bootes zu bestimmen.

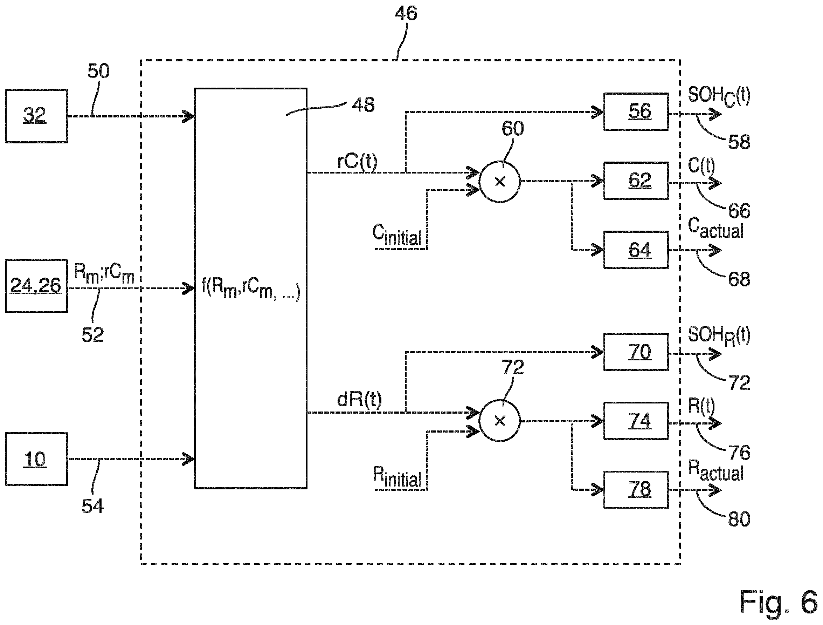

Figur 6 zeigt eine Ausführungsform des Antriebsbatteriemodells 46 in Form eines Blockdiagramms, das ein Alterungsmodell für die Antriebsbatterie 12 umfasst. Das Antriebsbatteriemodell 46 umfasst insbesondere ein mathematisches Modell 48 in Form einer Funktion oder eines Algorithmus, das in Abhängigkeit einer Vielzahl von Eingangsparameter einen ersten SOH-Wert, SOH_{C}, betreffend eine relative Kapazität der Antriebsbatterie 12, und einen zweiten SOH-Wert, SOH_{R}, betreffend einen Innenwiderstand der Antriebsbatterie 12, im Zeitverlauf berechnet.

Im Folgenden werden die Eingangsparameter für das mathematische Modell 48 unter Bezugnahme auf Figur 6 genauer beschrieben. Dem mathematischen Modell 48 werden die das Boot betreffende Systemkonfiguration und die die Nutzung des Boots betreffenden Betriebsbedingungen übergeben, wie in Figur 6 durch den Pfeil 50 angedeutet. Dies kann mittels der Prognoseeinheit 32 erfolgen. Weiterhin werden dem mathematischen Modell 48 gemessene Werte für die relative Kapazität rCₘ und den Innenwiderstand Rₘ der Antriebsbatterie 12 übermittelt, wie durch Pfeil 52 in Figur 6 angedeutet, die von dem Ladegerät 24 und/oder dem Messgerät 26 ermittelt und an das Antriebsbatteriemodell 46 übertragen werden. Weiterhin werden die im Betrieb der Antriebsbatterie 12 gemessenen Werte für die den Alterungszustand betreffenden Parameter aus dem Antriebssystem 10 ausgelesen und, wie durch Pfeil 54 in Figur 6 angedeutet, dem Antriebsbatteriemodell 46 übermittelt. In diesem Zusammenhang können beispielsweise Werte betreffend eine Lagerzeit, eine Lagerspannung, einen Belastungsstrom, insbesondere einen Entladungsstrom und einen Ladungsdurchsatz, eine Zelltemperatur und/oder einen Entladungsgrad von dem Batteriemanagementsystem 20 gemessen und an das Antriebsbatteriemodell 48 übermittelt werden.

Auf der Grundlage dieser Eingangsparameter berechnet das mathematische Modell 48 die relative Kapazität rC der Antriebsbatterie 12 im Zeitverlauf, also rC(t), und übermittelt diesen Wert an eine erste Verarbeitungseinheit 56, die daraus den ersten SOH-Wert, SOH_{C}, im Zeitverlauf berechnet und zur weiteren Verarbeitung ausgibt, wie durch Pfeil 58 in Figur 6 angedeutet. Die durch das mathematische Modell 48 berechneten Werte für die relative Kapazität rC(t) der Antriebsbatterie 12 werden weiterhin an eine zweite Verarbeitungseinheit 60 übermittelt. Die zweite Verarbeitungseinheit 60 empfängt weiterhin einen Wert für die Anfangskapazität Cᵢₙᵢₜᵢₐₗ der Antriebsbatterie 12, der einem Wert für die Kapazität der Antriebsbatterie 12 in einem neuwertigen Zustand, insbesondere vor Inbetriebnahme, entspricht, und multipliziert diesen mit den durch das mathematische Modell 48 bestimmten Werte für die relative Kapazität rC(t). Die so ermittelten Werte werden daraufhin einer dritten und einer vierten Verarbeitungseinheit 62, 64 übergeben. Die dritte Verarbeitungseinheit 62 ermittelt eine Restkapazität der Antriebsbatterie 12 im Zeitverlauf, also C(t), und, wie durch Pfeil 66 in Figur 6 gezeigt, gibt diese zur weiteren Verarbeitung aus. Die vierte Verarbeitungseinheit 64 bestimmt hingegen eine vorherrschende Restkapazität C_{actual} der Antriebsbatterie 12 und gibt diese aus, wie durch Pfeil 68 in Figur 6 gezeigt.

Weiterhin ist das mathematische Modell 48 dazu eingerichtet, auf der Grundlage der oben genannten Eingangsparameter eine Innenwiderstandserhöhung in Abhängigkeit der Zeit, dR(t), zu bestimmen und die ermittelten Werte an eine fünfte Verarbeitungseinheit 70 zu übergeben. Die fünfte Verarbeitungseinheit 70 ist dazu eingerichtet, den zweiten SOH-Wert, SOH_{R}, im Zeitverlauf zu berechnen und zur weiteren Verarbeitung auszugeben, wie durch Pfeil 72 in Figur 6 gezeigt. Die durch das mathematische Modell 48 berechneten Werte für die Innenwiderstandserhöhung dR(t) werden ferner einer sechsten Verarbeitungseinheit 72 übermittelt. Die sechste Verarbeitungseinheit 72 empfängt weiterhin einen Anfangsinnenwiderstandswert Rᵢₙᵢₜᵢₐₗ für die Antriebsbatterie 12, der einem Wert für den Innenwiderstand der Antriebsbatterie im neuwertigen Zustand, insbesondere vor deren Inbetriebnahme, entspricht, und multipliziert diesen mit den Werten für die Innenwiderstandserhöhung dR(t). Der so ermittelte Wert wird an eine siebte Verarbeitungseinheit 74 übergeben, die den Innenwiderstand der Antriebsbatterie 12 im zeitlichen Verlauf, R(t), bestimmt und, wie durch Pfeil 76 in Figur 6 gezeigt, zur Weiterverarbeitung ausgibt. Die durch die sechste Verarbeitungseinheit 72 ermittelten Werte werden weiterhin an eine achte Verarbeitungseinheit 78 übergeben, die einen vorherrschenden Innenwiderstandswert R_{actual} der Antriebsbatterie 12 ermittelt und, wie durch Pfeil 80 angedeutet, zur Weiterverarbeitung ausgibt.

Soweit anwendbar, können alle einzelnen Merkmale, die in den Ausführungsbeispielen dargestellt sind, miteinander kombiniert und/oder ausgetauscht werden, ohne den Bereich der Erfindung zu verlassen.

### Bezuqszeichenliste

- 10: Elektrisches Antriebssystem
- 12: Antriebsbatterie
- 14: Schiffsschraube
- 16: Antriebsmotor
- 18: Gehäuse
- 20: Batteriemanagementsystem
- 22: Schnittstelle
- 24: Ladegerät
- 26: Messgerät
- 28: Datenaustausch
- 30: Prognosesystem
- 32: Prognoseeinheit
- 34,36: Datenaustausch
- 38: Webserver
- 40: Datenträger
- 42: Datenaustausch
- 44: Grenzwert
- 46: Antriebsbatteriemodell
- 48: mathematisches Modell
- 50,52, 54, 58, 66, 68, 72, 76, 80: Datenaustausch
- 56, 60, 62, 64, 70, 72, 74, 78: Verarbeitungseinheit

## Patentansprüche

1. Verfahren zur Bestimmung der Lebensdauer einer Antriebsbatterie (12) eines Fahrzeugs, insbesondere eines Boots, umfassend die Schritte:
- Bestimmen einer Systemkonfiguration und/oder von Betriebsbedingungen des Fahrzeugs;
- Bereitstellen eines Antriebsbatteriemodells (46), das in Abhängigkeit der Systemkonfiguration und/oder der Betriebsbedingungen einen Alterungszustand der Antriebsbatterie (12) im Zeitverlauf angibt;
- Bestimmen wenigstens einer Bedingung, die das Erreichen eines Lebensende-Zustandes der Antriebsbatterie (12) festlegt; und
- Berechnen der Zeitdauer bis zum Erreichen des Lebensende-Zustandes auf der Grundlage des Antriebsbatteriemodells (46).

2. Verfahren nach Anspruch 1, bei dem das Bestimmen der Systemkonfiguration ein Bestimmen der Anzahl von Antriebsbatterien (12) und/oder eines Batterietyps und/oder einer Zusammenschaltung der Antriebsbatterien und/oder der Anzahl und Zusammenschaltung von Batteriezellen innerhalb der Antriebsbatterie und/oder der Verbraucher, insbesondere eines Antriebsmotors (16) und/oder weiterer Verbraucher, und/oder eines Ladegeräts (24) für die Antriebsbatterie (12) umfasst.

3. Verfahren nach Anspruch 1 oder 2, bei dem das Bestimmen der Betriebsbedingungen ein Bestimmen einer vorgesehenen Einsatzregion des Fahrzeugs und/oder von Klimabedingungen, insbesondere eines Klimaprofils, der vorgesehenen Einsatzregion und/oder einer in der Antriebsbatterie (12) vorherrschenden Temperatur und/oder einer Temperaturbeschränkung und/oder von Betriebszyklen, insbesondere von Lade- und Entladevorgänge umfasst.

4. Verfahren nach einem der Ansprüche 1 bis 3, bei dem das Antriebsbatteriemodell (46) auf der Grundlage der Systemkonfiguration und/oder der Betriebsbedingungen wenigstens einen den Alterungszustand der Antriebsbatterie (12) betreffenden Parameter als Funktion der Zeit angibt.

5. Verfahren nach Anspruch 4, bei dem der wenigstens eine Parameter ein Kennwert für den Alterungszustand und/oder ein innerer Widerstand und/oder eine nutzbare Kapazität und/oder eine Klemmspannung und/oder eine Selbstentladungseigenschaft und/oder eine Anzahl von Lade-Entladezyklen der Antriebsbatterie (12) ist.

6. Verfahren nach Anspruch 5, bei dem der Kennwert für den Alterungszustand eine nutzbare Kapazität relativ zu einer Anfangs-Kapazität der Antriebsbatterie (12), insbesondere unter Vorgabe einer konstanten Entlade-Dauerleistung angibt.

7. Verfahren nach einem der Ansprüche 1 bis 6, bei dem das Antriebsbatteriemodell (46) einen Wertebereich für den Alterungszustand, insbesondere für den wenigstens einen Parameter, in Abhängigkeit der Zeit angibt, wobei insbesondere eine Breite des Wertebereichs im Zeitverlauf größer wird.

8. Verfahren nach einem der Ansprüche 1 bis 7, bei dem das Bestimmen der wenigstens einen Bedingung ein Bestimmen eines Grenzwertes für den Alterungszustand, insbesondere den wenigstens einen Parameter, umfasst, bei dessen Erreichen der Lebensende-Zustand der Antriebsbatterie (12) vorliegt, wobei beim Berechnen der Zeitdauer bis zum Erreichen des Lebensende-Zustandes bestimmt wird, zu welchem Zeitpunkt der Grenzwert erreicht wird.

9. Verfahren nach einem der Ansprüche 1 bis 8, bei dem während der Lebensdauer des Fahrzeugs zu bestimmten Zeitpunkten der angegebene Alterungszustand oder der wenigstens eine angegebene Parameter an der Antriebsbatterie (12) gemessen und mit den durch das Antriebsbatteriemodell (46) zu diesen Zeitpunkten bestimmten Werten verglichen wird, und das Antriebsbatteriemodell (46) auf der Grundlage dieses Vergleichs angepasst wird.

10. Verfahren nach Anspruch 9, bei dem der durch das Antriebsbatteriemodell (46) angegebene Alterungszustand oder der wenigstens eine angegebene Parameter an der Antriebsbatterie (12) während eines Aufladevorgangs und/oder einer Wartung der Antriebsbatterie (12) und/oder nach Ablauf der berechneten Lebensdauer gemessen wird.

11. Verfahren nach einem der Ansprüche 1 bis 10, bei dem Betriebsbedingungen während der Lebensdauer der Antriebsbatterie (12) aufgezeichnet werden, und das Antriebsbatteriemodell (46) und/oder die bestimmten Betriebsbedingungen auf der Grundlage der aufgezeichneten Betriebsbedingungen angepasst werden/wird.

12. Verfahren nach einem der Ansprüche 1 bis 11, bei dem ein Parameter der Betriebsbedingungen in unterschiedliche Wertebereiche aufgeteilt wird und die Gesamtbetriebszeit der Antriebsbatterie (12) in jedem der durch die Wertebereiche festgelegten Betriebszustände über die Lebensdauer der Antriebsbatterie (12) aufgezeichnet wird.

13. Computerprogrammprodukt mit einem auf einem maschinenlesbaren Datenträger gespeicherten Programmcode zur Durchführung eines Verfahrens nach einem der Ansprüche 1 bis 12, wenn das Computerprogrammprodukt von einer Datenverarbeitungsanlage ausgeführt wird.

14. Prognosesystem (30) zur Bestimmung der Lebensdauer einer Antriebsbatterie (12) eines Fahrzeugs, insbesondere eines Boots, umfassend:
- einen Datenträger (40) mit einem darauf gespeicherten Computerprogrammprodukt nach Anspruch 13, und
- eine Prognoseeinheit (32) zum Ausführen des auf dem Datenträger (40) gespeicherten Computerprogrammprodukts.

15. Prognosesystem nach Anspruch 14, wobei der Datenträger (40) in einem Webserver (38) umfasst ist und die Prognoseeinheit (32) dazu eingerichtet ist, auf den Webserver (38) dezentral zuzugreifen, um das auf dem Datenträger (40) gespeicherten Computerprogrammprodukt auszuführen.
